# EUROPÄISCHE PATENTANMELDUNG

(11) **EP 2 487 727 A1**
(43) Veröffentlichungstag der Anmeldung: **15.08.2012**
(21) Anmeldenummer: 11001179.8
(22) Anmeldetag: 14.02.2011
(51) Int. Cl.: H01L 31/048, H01L 31/052, E04D 13/18

(54) **Solargenerator mit aktiver Hinterlüftung**

(71) Anmelder: Renusol GmbH, 51063 Köln (DE)
(72) Erfinder: Zschoch, Stefan, 10367 Berlin (DE); Kübsch, Michael, 16321 Bernau bei Berlin (DE)
(74) Vertreter: Graf von Stosch, Andreas

(57) **Zusammenfassung**

Es wird eine dachintegrierte Fotovoltaikanlage zur Montage auf einer Dachkonstruktion beschrieben, welche ein oder mehrere Solarmodule und eine oder mehrere Lüftungsöffnungen aufweist, wobei an oder in mindestens einer der Lüftungsöffnungen ein Ventilator angeordnet ist, und wobei der mindestens eine Ventilator dazu ausgelegt ist, in einem Zwischenraum zwischen der Fotovoltaikanlage und der Dachkonstruktion einen Luftstrom zur Hinterlüftung der Fotovoltaikanlage zu erzeugen.

## Beschreibung

Die Erfindung betrifft einen Eindeckrahmen zur Montage einer dachintegrierten Fotovoltaikanlage auf einer Dachkonstruktion, sowie eine dachintegrierte Fotovoltaikanlage. Des Weiteren betrifft die Erfindung ein Verfahren zur Hinterlüftung einer dachintegrierten Fotovoltaikanlage.

Es ist Aufgabe der Erfindung, die Betriebsbedingungen einer dachintegrierten Fotovoltaikanlage zu verbessern.

Die Aufgabe wird durch die unabhängigen Ansprüche gelöst. Vorteilhafte Weiterbildungen sind in den Unteransprüchen aufgeführt.

Der erfindungsgemäße Eindeckrahmen dient zur Montage einer dachintegrierten Fotovoltaikanlage auf einer Dachkonstruktion. Der Eindeckrahmen weist eine oder mehrere Lüftungsöffnungen auf, wobei an oder in mindestens einer der Lüftungsöffnungen ein Ventilator angeordnet ist, und wobei der mindestens eine Ventilator dazu ausgelegt ist, in einem Zwischenraum zwischen der Fotovoltaikanlage und der Dachkonstruktion einen Luftstrom zur Hinterlüftung der Fotovoltaikanlage zu erzeugen.

Die erfindungsgemäße dachintegrierte Fotovoltaikanlage ist zur Montage auf einer Dachkonstruktion ausgebildet. Die dachintegrierte Fotovoltaikanlage weist ein oder mehrere Solarmodule und eine oder mehrere Lüftungsöffnungen auf, wobei an oder in mindestens einer der Lüftungsöffnungen ein Ventilator angeordnet ist, und wobei der mindestens eine Ventilator dazu ausgelegt ist, in einem Zwischenraum zwischen der Fotovoltaikanlage und der Dachkonstruktion einen Luftstrom zur Hinterlüftung der Fotovoltaikanlage zu erzeugen.

Durch die Ausführungsformen der vorliegenden Erfindung wird eine aktive Hinterlüftung von dachintegrierten Fotovoltaikanlagen ermöglicht. Die von dem mindestens einen Ventilator geförderte Luft verursacht eine stetige Luftströmung im Zwischenraum zwischen den Solarmodulen und der Dachkonstruktion, wobei die unterhalb der Solarmodule befindliche aufgeheizte Luft nach draußen abtransportiert wird. Dadurch werden die Solarmodule von unten her gekühlt. Eine übermäßige Aufheizung der Solarmodule sowie der Luft im Zwischenraum unterhalb der Solarmodule wird dadurch wirksam verhindert. Insbesondere wird dadurch verhindert, dass es bei starker Sonneneinstrahlung zu einem Hitzestau kommt. Durch die aktive Hinterlüftung wird eine vorschnelle Degradation der Solarmodule infolge zu starker Aufheizung verhindert. Dadurch wird die Lebensdauer der Solarmodule tendenziell erhöht. Da die Solarmodule infolge der erfindungsgemäßen aktiven Hinterlüftung bei einer niedrigeren Temperatur betrieben werden als bisher, wird der Wirkungsgrad der Solarmodule bei der Umsetzung von Licht in elektrische Energie erhöht. Die kühlende Luftströmung im Zwischenraum zwischen Solarmodulen und Dachkonstruktion verbessert also die Stromausbeute des Solargenerators.

Gemäß einer vorteilhaften Ausführungsform der Erfindung umfasst die Fotovoltaikanlage ein oder mehrere Solarmodule, wobei der mindestens eine Ventilator dazu ausgelegt ist, in einem Zwischenraum zwischen den Solarmodulen und der Dachkonstruktion einen Luftstrom zur Hinterlüftung der Solarmodule zu erzeugen.

Gemäß einer vorteilhaften Ausführungsform der Erfindung handelt es sich bei mindestens einem Ventilator um einen elektrisch betriebenen Ventilator.

Gemäß einer vorteilhaften Ausführungsform der Erfindung handelt es sich bei mindestens einem Ventilator um einen solarstrombetriebenen Ventilator.

Gemäß einer vorteilhaften Ausführungsform der Erfindung ist mindestens einer der Ventilatoren mit einer eigenen separaten Solarzelle ausgestattet, welche einen zum Betrieb des Ventilators benötigten Strom liefert.

Gemäß einer vorteilhaften Ausführungsform der Erfindung ist an mindestens eine der Lüftungsöffnungen ein Lüftungsstutzen angebracht, wobei ein Ventilator in dem Lüftungsstutzen angeordnet ist.

Gemäß einer vorteilhaften Ausführungsform der Erfindung ist an mindestens einer der Lüftungsöffnungen ein Lüftungsstutzen angebracht, wobei ein Ventilator in dem Lüftungsstutzen angeordnet ist, und der Lüftungsstutzen umfasst eine Abdeckkappe mit einer Solarzelle, die den Strom zum Betrieb des im Lüftungsstutzen befindlichen Ventilators liefert.

Gemäß einer vorteilhaften Ausführungsform der Erfindung ist mindestens einer der Ventilatoren dazu ausgelegt, Luft von außen in den Zwischenraum zwischen der Fotovoltaikanlage und der Dachkonstruktion zu fördern.

Gemäß einer vorteilhaften Ausführungsform der Erfindung ist mindestens einer der Ventilatoren dazu ausgelegt, Luft aus dem Zwischenraum zwischen der Fotovoltaikanlage und der Dachkonstruktion nach außen zu fördern.

Gemäß einer vorteilhaften Ausführungsform der Erfindung umfasst der Eindeckrahmen ein oberes Abschlussblech und ein oder zwei seitliche Abschlussbleche.

Gemäß einer vorteilhaften Ausführungsform der Erfindung umfasst der Eindeckrahmen ein oberes Abschlussblech mit einer oder mehreren Lüftungsöffnungen, wobei an oder in mindestens einer der Lüftungsöffnungen ein Ventilator angeordnet ist.

Gemäß einer vorteilhaften Ausführungsform der Erfindung umfasst der Eindeckrahmen ein oder zwei seitliche Abschlussbleche mit einer oder mehreren Lüftungsöffnungen, wobei an oder in mindestens einer der Lüftungsöffnungen ein Ventilator angeordnet ist.

Gemäß einer vorteilhaften Ausführungsform der Erfindung strömt die von dem mindestens einen Ventilator aus dem Zwischenraum nach außen geförderte Luft durch mindestens eine an der Unterseite der Fotovoltaikanlage befindliche Lüftungsöffnung nach.

Das erfindungsgemäße Verfahren zur Hinterlüftung einer dachintegrierten Fotovoltaikanlage, welche auf einer Dachkonstruktion montiert ist, umfasst das Erzeugen eines Luftstroms zur Hinterlüftung der Fotovoltaikanlage in einem Zwischenraum zwischen der Fotovoltaikanlage und der Dachkonstruktion mittels mindestens einem in oder an einer Umrandung der Fotovoltaikanlage angebrachten Ventilator.

Es zeigen:
- Fig. 1: eine Dachkonstruktion mit einem dachintegrierten Solargenerator;
- Fig. 2A: ein oberes Abschlussblech des Solargenerators mit einem erfindungsgemäßen Entlüftungsstutzen;
- Fig. 2B: eine Seitenansicht eines Einzelblechs mit einem erfindungsgemäßen Entlüftungsstutzen;
- Fig. 2C: eine Schrägbildansicht eines Einzelblechs mit einem erfindungsgemäßen Entlüftungsstutzen;
- Fig. 3: einen Längsschnitt durch den oberen Teil eines Entlüftungsstutzens, in dem ein Ventilator angeordnet ist; und
- Fig. 4: eine Darstellung der durch den Ventilator hervorgerufenen Luftströmung zwischen dem Solarmodul und der Dachkonstruktion.

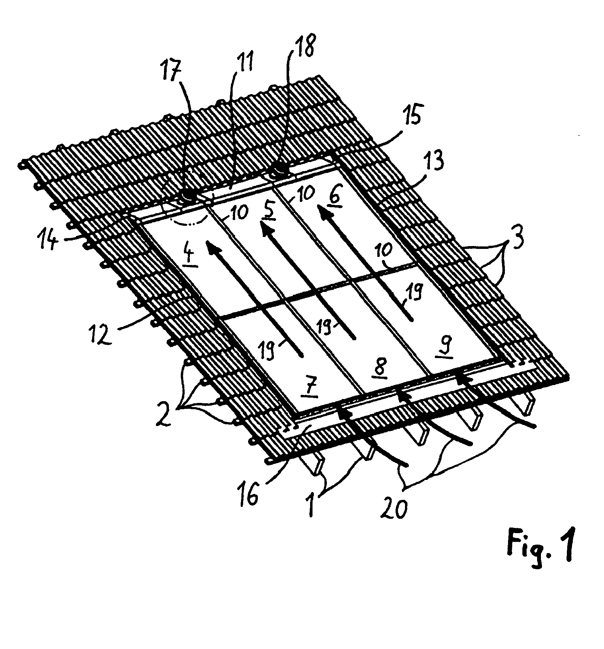

Fig. 1 zeigt eine dachintegrierte Fotovoltaikanlage, die in ein Schrägdach integriert ist. Das in Fig. 1 gezeigte Schrägdach weist eine Dachkonstruktion auf, wie sie in Deutschland üblicherweise verwendet wird. Die Dachkonstruktion wird von einer Vielzahl von Dachsparren 1 getragen, die von der Traufeseite des Daches zur Firstseite des Daches verlaufen. Auf die Dachsparren 1 sind eine Vielzahl von Dachlatten 2 aufgenagelt. Die Dachlatten 2 verlaufen in horizontaler Richtung senkrecht zu den Dachsparren 1. Die Dachlatten 2 dienen zum Haltern der Dachsteine. Dabei wird in jede Dachlatte 2 eine Reihe 3 von Dachsteinen eingehängt.

Eine dachintegrierte Fotovoltaikanlage wird in einem bestimmten Bereich des Daches anstelle der Dachsteine auf den Dachlatten 2 montiert. Die in Fig. 1 gezeigte Fotovoltaikanlage umfasst sechs Solarmodule 4 bis 9, die zusammen ein Solarmodulfeld bilden. Zur Montage der Solarmodule 4 bis 9 werden die Solarmodule 4 bis 9 auf eine Mehrzahl von Montageschienen aufgelegt und mit Hilfe von speziellen Montageelementen mit den Montageschienen verklemmt oder verschraubt. Nach der Montage der Solarmodule 4 bis 9 werden Abdeckleisten 10 in die Zwischenräume zwischen den Solarmodulen 4 bis 9 eingeklemmt.

Das Solarmodulfeld wird mittels eines Eindeckrahmens auf der Dachkonstruktion montiert, wobei der Eindeckrahmen ein oberes Abschlussblech 11, seitliche Abschlussbleche 12, 13 sowie Eckbleche 14, 15 umfasst. Das obere Abschlussblech 11 bildet den oberen Abschluss des Solargenerators und verläuft entlang der Oberkante des Solarmodulfelds. Vorzugsweise handelt es sich bei dem oberen Abschlussblech 11 um ein Aluminiumblech oder um ein Titan—Zink-Blech.

Insbesondere Titan-Zink-Bleche werden für Dachkonstruktionen häufig eingesetzt. Das obere Abschlussblech 11 kann beispielsweise aus mehreren Einzelblechen zusammengesetzt sein, die miteinander verlötet (falls aus Titan-Zink bestehend) oder verklebt werden (falls aus Aluminium bestehend).

Als seitlicher Abschluss des Solarmodulfelds sind zwei seitliche Abschlussbleche 12, 13 vorgesehen, wobei das seitliche Abschlussblech 12 den linken Rand des Solarmodulfelds abschließt und das seitliche Abschlussblech 13 den rechten Rand des Solarmodulfelds abschließt. Die seitlichen Abschlussbleche 12, 13 bestehen vorzugsweise ebenfalls aus Aluminiumblech oder aus Titan-Zink-Blech und sind vorzugsweise ebenfalls aus mehreren Einzelblechen zusammengesetzt. Am oberen linken Eck und am oberen rechten Eck des Solarmodulfelds sind jeweils Eckbleche 14, 15 vorgesehen, die einen Übergang zwischen dem oberen Abschlussblech 11 und den seitlichen Abschlussblechen 12, 13 bilden. Auf diese Weise wird ein Eindeckrahmen gebildet, der aus dem linken seitlichen Abschlussblech 12, dem Eckblech 14, dem oberen Abschlussblech 11, dem Eckblech 15 und dem rechten seitlichen Abschlussblech 13 besteht. Dieser Eindeckrahmen bildet den Übergang zwischen der Fotovoltaikanlage und dem mit Dachsteinen eingedeckten Bereich des Schrägdachs. An der Unterseite des Solarmodulfelds ist eine Bleischürze 16 vorgesehen, die entlang der Unterkante des Solarmodulfelds verläuft und den unteren Abschluss des Solarmodulfelds bildet. Die Bleischürze 16 besteht aus flexiblem Material und folgt der Kontur der unterhalb der Bleischürze 16 angeordneten Dachsteine.

Bei dachintegrierten Fotovoltaikanlagen des in Fig. 1 gezeigten Typs kommt es zur Ausbildung eines Zwischenraums unterhalb der Solarmodule 4 bis 9, also zwischen der Dachkonstruktion und den auf Montageschienen befestigten Solarmodulen 4 bis 9. Bei starker Sonneneinstrahlung werden sowohl die Solarmodule 4 bis 9 selbst als auch die Luft in dem darunterliegenden Zwischenraum stark aufgeheizt, und es kann zu einem Hitzestau kommen. Die Aufheizung der Solarmodule 4 bis 9 beeinträchtigt den Wirkungsgrad der Solarmodule bei der Umsetzung von Licht in elektrische Energie, denn der Wirkungsgrad der Solarmodule sinkt mit zunehmender Temperatur. Es ist zwar bekannt, mit Hilfe von Lüftungsschlitzen für eine gewisse passive Hinterlüftung des Solarmodulfelds zu sorgen, mit derartigen Techniken der passiven Hinterlüftung werden die mit der Aufheizung des Solarmodulfelds zusammenhängenden Probleme jedoch nur unvollständig gelöst.

In vielen Ländern werden Dachkonstruktionen verwendet, bei denen das Problem der Aufheizung von dachintegrierten Solaranlagen noch ausgeprägter ist als bei der in Deutschland üblichen Dachkonstruktion. Insbesondere in südeuropäischen Ländern, z.B. in Südfrankreich, Spanien und Italien, wird eine Dachkonstruktionen verwendet, bei der das Dach aus Hohlsteinen aufgebaut ist, die mit Beton vergossen werden. Die Dachsteine werden dann in das Betonbett des Daches eingelegt. Wenn eine Fotovoltaikanlage in eine derartige Dachkonstruktion integriert wird, dann wird durch das Betonbett eine passive Hinterlüftung der Solarmodule fast völlig verhindert. Infolge der fehlenden bzw. stark eingeschränkten Hinterlüftung heizt sich bei Sonneneinstrahlung der Zwischenraum zwischen den Solarmodulen und dem Betonbett stark auf, und auch die Solarmodule selbst heizen sich stark auf. Durch diese starke Aufheizung der Solarmodule sinkt der Wirkungsgrad der Fotovoltaikanlage. Der entstehende Hitzestau kann darüber hinaus zu einer vorzeitigen Degradation der Solarmodule sowie zu sonstigen Beschädigungen und Beeinträchtigungen der Fotovoltaikanlage führen.

Darüber hinaus gibt es weitere Beispiele von Dachkonstruktionen, bei denen die passive Hinterlüftung sehr schwach bzw. gar nicht ausgeprägt ist, so dass es bei dachintegrierten Fotovoltaikanlagen häufig zu Problemen kommt, die durch eine übermäßige Aufheizung während des Betriebs entstehen. Beispielsweise werden bei Schieferdächern die Schiefer auf eine komplett geschlossene Holzverschalung genagelt. Als Dachkonstruktion wird hier also eine vollkommen geschlossene Holzplatte verwendet. Wenn in ein derartiges Schieferdach eine Fotovoltaikanlage integriert wird, dann ist der Zwischenraum zwischen den Solarmodulen und der Holzverschalung hermetisch abgeschlossen, und die passive Hinterlüftung ist schwach bzw. überhaupt nicht ausgeprägt. Bei Solargeneratoren, die in ein Schieferdach integriert sind, kommt es daher häufig zu Problemen, die durch übermäßige Aufheizung bzw. durch einen Hitzestau während des Betriebs verursacht sind.

Bei der erfindungsgemäßen Lösung sind deshalb insbesondere im oberen Abschlussblech 11, optional aber eventuell auch in den seitlichen Abschlussblechen 12, 13 ein oder mehrere Ventilatoren 17, 18 vorgesehen, die eine aktive Hinterlüftung der dachintegrierten Solaranlage bewirken. Die Ventilatoren 17, 18 werden vorzugsweise elektrisch betrieben. Die Ventilatoren 17, 18 können innerhalb von Lüftungsöffnungen des oberen Abschlussblechs 11 oder der seitlichen Abschlussbleche 12, 13 angebracht sein. Alternativ dazu können an dem oberen Abschlussblech 11 und eventuell auch an den seitlichen Abschlussblechen 12, 13 Lüftungsrohrabschnitte vorgesehen sein, wobei die Ventilatoren innerhalb der Lüftungsrohrabschnitte angeordnet sind. Die Ventilatoren 17, 18 sind dazu ausgelegt, eine Luftströmung im Zwischenraum zwischen den Solarmodulen 4 bis 9 und der Dachkonstruktion hervorzurufen und dadurch für eine aktive Hinterlüftung der Solarmodule 4 bis 9 zu sorgen.

Vorzugsweise sind die im oberen Abschlussblech 11 angeordneten Ventilatoren 17, 18 dazu ausgelegt, Luft aus dem unterhalb der Solarmodule 4 bis 9 befindlichen Zwischenraum herauszufördern. Dadurch wird in dem Zwischenraum unterhalb des Solarmodulfelds eine Luftströmung in Richtung von der Traufeseite zur Firstseite des Schrägdachs erzeugt, wie dies in Fig. 1 durch die Pfeile 19 veranschaulicht ist. Die abgeförderte Luft wird durch frische Luft ersetzt, die von der Unterseite des Solarmodulfelds her entsprechend den Pfeilen 20 in den unterhalb der Solarmodule 4 bis 9 befindlichen Zwischenraum nachströmt. Durch die Förderleistung der entlang des oberen Abschlussblechs 11 und zusätzlich optional auch entlang der seitlichen Abschlussblechen 12, 13 angeordneten Ventilatoren wird eine aktive Hinterlüftung der Solarmodule 4 bis 9 erzielt. Durch die von außen entsprechend den Pfeilen 20 nachströmende Frischluft wird eine stetige Kühlung der Solarmodule von der Unterseite her erzielt. Dadurch wird ein Hitzestau im Zwischenraum unterhalb der Solarmodule vermieden. Auch bei starker Sonneneinstrahlung kann die Betriebstemperatur der Solarmodule 4 bis 9 infolge des kühlenden Luftstroms abgesenkt werden, und dadurch steigt der Wirkungsgrad der Solarmodule bei der Umsetzung von Licht in elektrische Energie an.

Der Einsatz der erfindungsgemäßen aktiven Hinterlüftung ist insbesondere bei Dachkonstruktionen von Vorteil, bei denen keine bzw. nur eine geringfügige passive Hinterlüftung gegeben ist. Insbesondere bei Dachkonstruktionen des in Frankreich häufig verwendeten Typs, bei denen die Dachsteine in eine Betonschicht eingelegt werden, ist eine aktive Hinterlüftung sinnvoll. Darüber hinaus empfiehlt sich der Einsatz der erfindungsgemäßen aktiven Hinterlüftung insbesondere bei Schieferdächern.

Bei der bislang anhand von Fig. 1 beschriebenen Ausführungsform sind die Ventilatoren 17, 18 zur aktiven Entlüftung des Zwischenraums zwischen Dach und Solarmodulfeld ausgebildet, d. h. die Ventilatoren 17, 18 fördern die Luft aus dem Zwischenraum heraus ins Freie. Diese Förderrichtung ist von Vorteil, weil sie natürliche Strömungsrichtung der aufgeheizten Luft von unten nach oben unterstützt.

Alternativ dazu ist es jedoch möglich, Ventilatoren zur aktiven Belüftung des Zwischenraums einzusetzen, welche Luft von außen in den Zwischenraum hineinfördern. Auch durch eine Förderung von Luft in den Zwischenraum hinein kann eine Luftströmung innerhalb des Zwischenraums zwischen Dach und Solarmodulfeld erzeugt werden. Beispielsweise könnte vorgesehen sein, dass an einem der seitlichen Abschlussbleche 12, 13 Ventilatoren angebracht sind, die Luft in den Zwischenraum hineinfördern, während am entgegengesetzten seitlichen Abschlussblech Ventilatoren angeordnet sind, die Luft aus dem Zwischenraum nach draußen fördern. Mit einer derartigen Anordnung ließe sich beispielsweise eine Luftströmung von links nach rechts oder von rechts nach links innerhalb des Zwischenraums erzeugen. Denkbar sind beliebige Kombinationen von belüftenden und entlüftenden Ventilatoren, die dazu ausgelegt sind, im Zwischenraum unterhalb der Solarmodule 4 bis 9 aktiv eine Luftströmung zu erzeugen und somit für eine wirksame Hinterlüftung der Solarmodule zu sorgen. Je nach Auslegung des Solargenerators kann es hierzu sinnvoll sein, ausschließlich entlüftende Ventilatoren zu verwenden oder ausschließlich belüftende Ventilatoren zu verwenden, oder aber eine beliebige Kombination von entlüftenden und belüftenden Ventilatoren zu verwenden. Durch geeignete Auswahl und Dimensionierung der Ventilatoren kann ein gewünschtes Strömungsprofil im Zwischenraum erzeugt werden.

Die zum Betrieb der Ventilatoren erforderliche elektrische Energie kann auf verschiedene Weise bereitgestellt werden. Eine erste Möglichkeit ist, den bzw. die Ventilatoren an das Stromnetz anzuschließen, so dass der zum Betrieb der Ventilatoren erforderliche Strom durch das reguläre Stromnetz zur Verfügung gestellt wird.

Entsprechend einer alternativen Ausführungsform kann vorgesehen sein, dass der bzw. die Ventilatoren mit Strom betrieben werden, der von den Solarmodulen 4 bis 9 erzeugt wird. In diesem Fall würden die Ventilatoren von der durch den Solargenerator erzeugten elektrischen Energie einen Teil abzweigen, um eine aktive Hinterlüftung der Solarmodule 4 bis 9 zu ermöglichen und einen Hitzestau im Zwischenraum unterhalb der Solarmodule 4 bis 9 zu verhindern.

Gemäß einer weiteren alternativen Ausführungsform der Erfindung sind die Ventilatoren mit einer eigenen separaten Solarzelle ausgestattet und können sich somit selbst mit Betriebsstrom versorgen. Beispielsweise kann die Solarzelle an der Oberseite des Solarventilators, beispielsweise auf einer Abdeckkappe, angebracht sein. Wenn der Solarventilator mit einer eigenen separaten Solarzelle ausgestattet wird, ist es nicht mehr notwendig, dass die zum Betrieb des Solarventilators erforderliche Energie von den Solarmodulen 4 bis 9 abgezweigt wird. Die Energieerzeugung der Solarmodule 4 bis 9 wird bei dieser Ausführungsform also nicht geschmälert. Ein weiterer Vorteil bei allen solarbetriebenen Ventilatoren ist, dass der Betriebsstrom und somit auch die Förderleistung des Ventilators mit steigender Sonneneinstrahlung zunimmt, weil die Solarmodule bzw. die Solarzelle mit steigendem Lichteinfall mehr elektrische Leistung produzieren. Bei starker Sonneneinstrahlung erzeugen der bzw. die Ventilatoren daher einen stärkeren Luftstrom, so dass die Solarmodule 4 bis 9 besser gekühlt werden. Bei schwächerer Sonneneinstrahlung dagegen wird nur ein relativ schwacher Luftstrom im Zwischenraum unterhalb der Solarmodule 4 bis 9 erzeugt. Bei solarbetriebenen Ventilatoren passt sich die Förderleistung des Ventilators automatisch an den Sonneneinfall und damit auch an den Grad der Aufheizung an, so dass auch bei starker Sonneneinstrahlung eine wirksame Kühlung und somit ein Schutz vor Hitzestau gegeben ist. Beim Betrieb des Solarventilators mit Solarstrom erhält man also automatisch ein Regelkreisverhalten, wobei die Förderleistung automatisch an die einfallende Lichtmenge und an die resultierende Aufheizung anpasst wird.

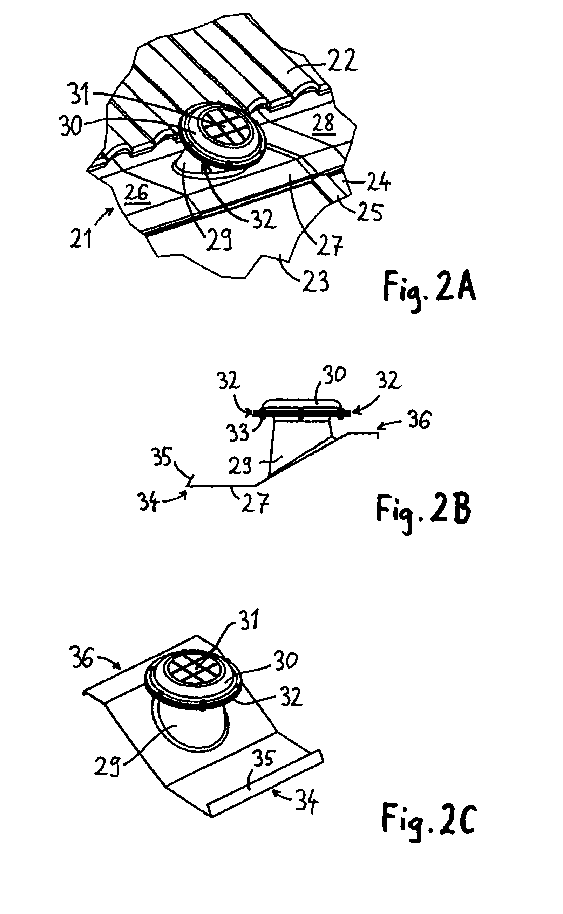

In den Fig. 2A bis 2C sind verschiedene Ansichten des Solarventilators gezeigt, der in ein Be- oder Entlüftungsrohr integriert ist. Der in den Fig. 2A bis 2C gezeigte Solarventilator ist mit einer eigenen separaten Solarzelle ausgestattet, die den zum Betrieb des Solarventilators benötigten Strom liefert. Fig. 2A zeigt ein oberes Abschlussblech 21, das an der Oberseite eines Solargenerators angeordnet ist. Das obere Abschlussblech bildet einen Übergang zwischen einer Reihe 22 von Dachsteinen und den nur teilweise erkennbaren Solarmodulen 23, 24. Außerdem ist ein Abschnitt der zwischen den Solarmodulen 23, 24 angeordneten Abdeckleiste 25 zu erkennen. Das obere Abdeckblech 21 besteht aus mehreren miteinander verbundenen Einzelblechen 26, 27, 28. Bei den Blechen handelt es sich vorzugsweise um Aluminiumbleche oder um Titan-Zink-Bleche. Entsprechend der erfindungsgemäßen Lösung weist das obere Abdeckblech 21 einen Entlüftungsstutzen mit einem darin angeordneten elektrisch betriebenen Ventilator auf. Hierzu ist an einer Entlüftungsöffnung des Einzelblechs 27 ein Rohrabschnitt 29 angebracht, und innerhalb dieses Rohrabschnitts 29 befindet sich der elektrisch betriebene Ventilator. Der Rohrabschnitt 29 wird durch eine Abdeckkappe 30 abgedeckt. Auf der Abdeckkappe 30 ist eine Solarzelle 31 angebracht, die den zum Betrieb des Ventilators benötigten Strom erzeugt. Die vom Ventilator geförderte Luft strömt durch einen rund um den Entlüftungsstutzen herum verlaufenden Austrittsspalt 32 aus.

In Fig. 2B ist eine Seitenansicht des Einzelblechs 27 und des darauf angebrachten Entlüftungsstutzens gezeigt. Da es sich in den Fig. 2A, 2B, 2C um unterschiedliche Ansichten ein- und desselben Gegenstands handelt, werden in Fig. 2B und Fig. 2C dieselben Bezugszeichen wie in Fig. 2A verwendet. In Fig. 2B sind das Einzelblech 27, der Rohrabschnitt 29 sowie ein an den Rohrabschnitt 29 angeformter Flansch 33 zu erkennen. Die Abdeckkappe 30 ist auf den Flansch 33 so aufgeschraubt, dass zwischen dem Flansch 33 und der Abdeckkappe 30 der rund um den Entlüftungsstutzen herum verlaufender Austrittsspalt 32 gebildet wird. Durch diesen Austrittsspalt 32 strömt die Luft aus, die von dem im Rohrabschnitt 29 befindlichen Ventilator gefördert wird. Auf der Oberseite der Abdeckkappe 30 ist die Solarzelle 31 angebracht, die den Strom zum Betrieb der Ventilators liefert. Das Einzelblech 27 weist ein firstseitiges Ende 34 auf, das in Richtung zu den Dachsteinen 22 hin angeordnet ist. Am firstseitigen Ende 34 weist das Blech einen Knick 35 auf. Durch diesen Knick 35 wird verhindert, dass Wasser vom oberen Abschlussblech 21 aus in den Bereich unterhalb der Dachsteine 22 eindringen kann. Das Einzelblech 27 weist außerdem ein traufeseitiges Ende 36 auf, das in Richtung zu den Solarmodulen 23, 24 hin orientiert ist.

In Fig. 2C ist eine Schrägbilddarstellung des Einzelblechs 27 gezeigt. Zu erkennen sind das firstseitige Ende 34 mit dem Knick 35 sowie das traufeseitige Ende 36. Außerdem ist der Entlüftungsstutzen zu sehen, der den Rohrabschnitt 29, die Abdeckkappe 30, den Austrittsspalt 32 sowie die an der Oberseite der Abdeckkappe 30 angebrachte Solarzelle 31 umfasst.

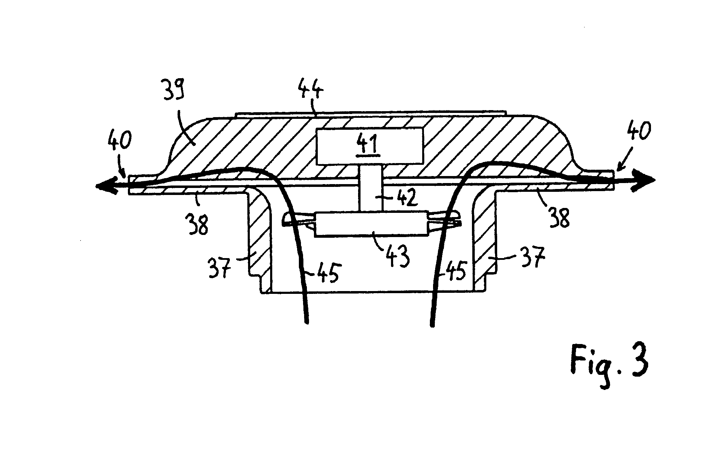

In Fig. 3 ist ein Längsschnitt durch den oberen Teil des Entlüftungsstutzens und den dort befindlichen Ventilator gezeigt. Dabei sind ein Teil eines Rohrabschnitts 37, ein an den Rohrabschnitt 37 angeformter Flansch 38 sowie eine Abdeckkappe 39 zu erkennen. Die Abdeckkappe 39 ist auf den Flansch 38 so aufgeschraubt, dass zwischen dem Flansch 38 und der Abdeckkappe 39 ein rund um die Abdeckkappe 39 herum verlaufender Austrittsspalt 40 entsteht, durch den die vom Ventilator geförderte Luft austreten kann. Darüber hinaus ist in Fig. 3 ein Elektromotor 41 zu sehen, der über eine Antriebswelle 42 ein Flügelrad 43 antreibt. Der Elektromotor 41 bildet zusammen mit der Antriebswelle 42 und dem Flügelrad 43 den Ventilator. Der zum Betrieb des Elektromotors 41 erforderliche Strom wird von einer Solarzelle 44 bereitgestellt, die sich an der Oberseite der Abdeckkappe 39 befindet. Durch das rotierende Flügelrad 43 wird Luft aus dem Zwischenraum zwischen den Solarmodulen und dem Dach angesaugt. Die vom Ventilator geförderte Luft strömt dann ringsum durch den Austrittsspalt 40 aus dem Entlüftungsstutzen aus. Der vom Ventilator geförderte Luftstrom ist in Fig. 3 durch die beiden Pfeile 45 dargestellt.

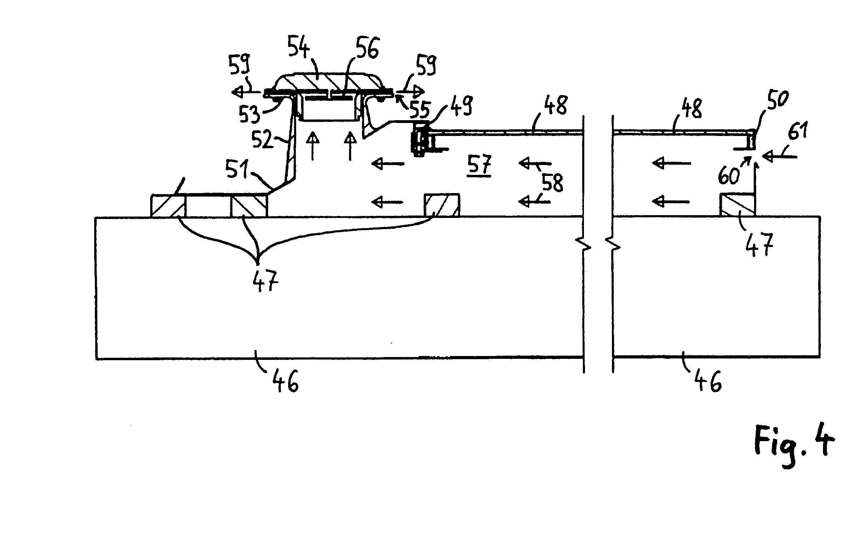

Fig. 4 zeigt einen Längsschnitt durch einen dachintegrierten Solargenerator, der mit einer aktiven Hinterlüftung gemäß den Ausführungsformen der vorliegenden Erfindung ausgestattet ist. Die Dachkonstruktion umfasst Dachsparren 46 und auf die Dachsparren aufgenagelte Dachlatten 47. Von dem Solargenerator sind in Fig. 4 ein Solarmodul 48 sowie Montageschienen 49, 50 zu erkennen, auf denen das Solarmodul 48 montiert ist. Der Solargenerator wird mittels eines Eindeckrahmens auf die Dachkonstruktion montiert, wobei der Eindeckrahmen ein oberes Abschlussblech sowie seitliche Abschlussbleche umfasst. In Fig. 4 ist ein Einzelblech 51 des oberen Abschlussblechs zu erkennen, wobei das Einzelblech 50 mit einem Entlüftungsstutzen und einem Ventilator ausgestattet ist. Der Entlüftungsstutzen umfasst einen Rohrabschnitt 52 mit einem angeformten Flansch 53 sowie eine Abdeckkappe 54, die auf den Flansch 53 so aufgeschraubt ist, dass ein Austrittsspalt 55 gebildet wird. Innerhalb des Rohrabschnitts 52 ist ein Ventilator 56 angeordnet, der von einem Elektromotor angetrieben wird. Der Ventilator 56 ist dazu ausgelegt, Luft aus dem Zwischenraum 57 zwischen dem Solarmodul 48 und der Dachkonstruktion anzusaugen und nach draußen zu fördern. Dadurch wird in dem Zwischenraum 56 eine entsprechend den Pfeilen 58 verlaufende Luftströmung erzeugt. Die vom Ventilator 55 geförderte Luft strömt durch den Austrittsspalt 54 ins Freie, wie dies durch die Pfeile 59 veranschaulicht ist. An der Unterseite des Solarmoduls 48 strömt frische Luft von außen durch den Lüftungsschlitz 60 in den Zwischenraum 57, wie dies durch den Pfeil 61 veranschaulicht ist.

Durch die erfindungsgemäße aktive Hinterlüftung wird im Zwischenraum 57 eine stetige Luftströmung in Richtung der Pfeile 58 erzeugt, welche die infolge der Sonneneinstrahlung aufgeheizte Luft abtransportiert und das Solarmodul 48 von unten kühlt. Dadurch wird einer übermäßigen Aufheizung der Luft im Zwischenraum 57 entgegengewirkt.

## Patentansprüche

1. Ein Eindeckrahmen zur Montage einer dachintegrierten Fotovoltaikanlage auf einer Dachkonstruktion, wobei der Eindeckrahmen aufweist:
eine oder mehrere Lüftungsöffnungen,
wobei an oder in mindestens einer der Lüftungsöffnungen ein Ventilator (56) angeordnet ist, und
wobei der mindestens eine Ventilator (56) dazu ausgelegt ist, in einem Zwischenraum (57) zwischen der Fotovoltaikanlage und der Dachkonstruktion einen Luftstrom (19, 58) zur Hinterlüftung der Fotovoltaikanlage zu erzeugen.

2. Eindeckrahmen nach Anspruch 1, **dadurch gekennzeichnet, dass** die Fotovoltaikanlage ein oder mehrere Solarmodule umfasst, wobei der mindestens eine Ventilator dazu ausgelegt ist, in einem Zwischenraum zwischen den Solarmodulen und der Dachkonstruktion einen Luftstrom zur Hinterlüftung der Solarmodule zu erzeugen.

3. Eindeckrahmen nach Anspruch 1 oder Anspruch 2, **gekennzeichnet durch** mindestens eines der folgenden Merkmale:
bei mindestens einem Ventilator handelt es sich um einen elektrisch betriebenen Ventilator;
bei mindestens einem Ventilator handelt es sich um einen solarstrombetriebenen Ventilator;
mindestens einer der Ventilatoren ist mit einer eigenen separaten Solarzelle ausgestattet, welche einen zum Betrieb des Ventilators benötigten Strom liefert;
an mindestens einer der Lüftungsöffnungen ist ein Lüftungsstutzen angebracht, wobei ein Ventilator in dem Lüftungsstutzen angeordnet ist;
an mindestens einer der Lüftungsöffnungen ist ein Lüftungsstutzen angebracht, wobei ein Ventilator in dem Lüftungsstutzen angeordnet ist, und der Lüftungsstutzen umfasst eine Abdeckkappe mit einer Solarzelle, die den Strom zum Betrieb des im Lüftungsstutzen befindlichen Ventilators liefert.

4. Eindeckrahmen nach einem der Ansprüche 1 bis 3, **gekennzeichnet durch** mindestens eines der folgenden Merkmale:
mindestens einer der Ventilatoren ist dazu ausgelegt, Luft von außen in den Zwischenraum zwischen der Fotovoltaikanlage und der Dachkonstruktion zu fördern;
mindestens einer der Ventilatoren ist dazu ausgelegt, Luft aus dem Zwischenraum zwischen der Fotovoltaikanlage und der Dachkonstruktion nach außen zu fördern.

5. Eindeckrahmen nach einem der Ansprüche 1 bis 4, **gekennzeichnet durch** mindestens eines der folgenden Merkmale:
der Eindeckrahmen umfasst ein oberes Abschlussblech und ein oder zwei seitliche Abschlussbleche;
der Eindeckrahmen umfasst ein oberes Abschlussblech mit einer oder mehreren Lüftungsöffnungen, wobei an oder in mindestens einer der Lüftungsöffnungen ein Ventilator angeordnet ist;
der Eindeckrahmen umfasst ein oder zwei seitliche Abschlussbleche mit einer oder mehreren Lüftungsöffnungen, wobei an oder in mindestens einer der Lüftungsöffnungen ein Ventilator angeordnet ist;
die von dem mindestens einen Ventilator aus dem Zwischenraum nach außen geförderte Luft strömt **durch** mindestens eine an der Unterseite der Fotovoltaikanlage befindliche Lüftungsöffnung nach.

6. Eine dachintegrierte Fotovoltaikanlage zur Montage auf einer Dachkonstruktion, welche aufweist:
ein oder mehrere Solarmodule (4-9, 48);
eine oder mehrere Lüftungsöffnungen,
wobei an oder in mindestens einer der Lüftungsöffnungen ein Ventilator (56) angeordnet ist, und
wobei der mindestens eine Ventilator (56) dazu ausgelegt ist, in einem Zwischenraum (57) zwischen der Fotovoltaikanlage und der Dachkonstruktion einen Luftstrom (19, 58) zur Hinterlüftung der Fotovoltaikanlage zu erzeugen.

7. Fotovoltaikanlage nach Anspruch 6, **gekennzeichnet durch** mindestens eines der folgenden Merkmale:
bei mindestens einem Ventilator handelt es sich um einen elektrisch betriebenen Ventilator;
bei mindestens einem Ventilator handelt es sich um einen solarstrombetriebenen Ventilator;
mindestens einer der Ventilatoren ist mit einer eigenen separaten Solarzelle ausgestattet, welche einen zum Betrieb des Ventilators benötigten Strom liefert;
an mindestens einer der Lüftungsöffnungen ist ein Lüftungsstutzen angebracht, wobei ein Ventilator in dem Lüftungsstutzen angeordnet ist;
an mindestens einer der Lüftungsöffnungen ist ein Lüftungsstutzen angebracht, wobei ein Ventilator in dem Lüftungsstutzen angeordnet ist, und der Lüftungsstutzen umfasst eine Abdeckkappe mit einer Solarzelle, die den Strom zum Betrieb des im Lüftungsstutzen befindlichen Ventilators liefert.

8. Fotovoltaikanlage nach Anspruch 6 oder Anspruch 7, **gekennzeichnet durch** mindestens eines der folgenden Merkmale:
mindestens einer der Ventilatoren ist dazu ausgelegt, Luft von außen in den Zwischenraum zwischen der Fotovoltaikanlage und der Dachkonstruktion zu fördern;
mindestens einer der Ventilatoren ist dazu ausgelegt, Luft aus dem Zwischenraum zwischen der Fotovoltaikanlage und der Dachkonstruktion nach außen zu fördern.

9. Fotovoltaikanlage nach einem der Ansprüche 6 bis 8, **gekennzeichnet durch** mindestens eines der folgenden Merkmale:
die Fotovoltaikanlage umfasst einen Eindeckrahmen mit einer oder mehreren Lüftungsöffnungen, wobei an oder in mindestens einer der Lüftungsöffnungen ein Ventilator angeordnet ist;
die Fotovoltaikanlage umfasst einen Eindeckrahmen mit einem oberen Abschlussblech und ein oder zwei seitlichen Abschlussblechen;
die Fotovoltaikanlage umfasst ein oberes Abschlussblech mit einer oder mehreren Lüftungsöffnungen, wobei an oder in mindestens einer der Lüftungsöffnungen ein Ventilator angeordnet ist;
die Fotovoltaikanlage umfasst ein oder zwei seitliche Abschlussbleche mit einer oder mehreren Lüftungsöffnungen, wobei an oder in mindestens einer der Lüftungsöffnungen ein Ventilator angeordnet ist;
die von dem mindestens einen Ventilator aus dem Zwischenraum nach außen geförderte Luft strömt **durch** mindestens eine an der Unterseite der Fotovoltaikanlage befindliche Lüftungsöffnung nach.

10. Fotovoltaikanlage nach einem der Ansprüche 6 bis 9, **dadurch gekennzeichnet, dass** die dachintegrierte Fotovoltaikanlage zur Montage auf einer Dachkonstruktion, wie sie in südeuropäischen Ländern üblich ist, oder auf einem Schieferdach ausgebildet ist.

11. Verfahren zur Hinterlüftung einer dachintegrierten Fotovoltaikanlage, welche auf einer Dachkonstruktion montiert ist, wobei das Verfahren aufweist:
Erzeugen eines Luftstroms (19, 58) zur Hinterlüftung der Fotovoltaikanlage in einem Zwischenraum (57) zwischen der Fotovoltaikanlage und der Dachkonstruktion mittels mindestens einem in oder an einer Umrandung der Fotovoltaikanlage angebrachten Ventilator (56).

12. Verfahren nach Anspruch 11, **gekennzeichnet durch** mindestens einen der folgenden Schritte:
Belüften des zwischen der Fotovoltaikanlage und der Dachkonstruktion befindlichen Zwischenraums mittels mindestens einem Ventilator, der Luft von außen in den Zwischenraum fördert;
Entlüften des zwischen der Fotovoltaikanlage und der Dachkonstruktion befindlichen Zwischenraums mittels mindestens einem Ventilator, der Luft aus dem Zwischenraum nach außen fördert.
